# EUROPÄISCHE PATENTSCHRIFT

(11) **EP 0 716 453 B1**
(45) Veröffentlichungstag und Bekanntmachung des Hinweises auf die Patenterteilung: **25.02.1998**
(21) Anmeldenummer: 95117635.3
(22) Anmeldetag: 07.11.1995
(51) Int. Cl.: H01L 29/10, H01L 29/786, H01L 29/423, H01L 21/336

(54) **MOSFET auf SOI-Substrat**
MOSFET on SOI-substrate
MOSFET sur substrat du type SOI

(30) Priorität: 24.11.1994 DE 4441901
(43) Veröffentlichungstag der Anmeldung: 12.06.1996
(73) Patentinhaber: SIEMENS AKTIENGESELLSCHAFT, 80333 München (DE)
(72) Erfinder: Kerber, Martin, Dr., D-81827 München (DE); Mahnkopf, Reinhard, Dr., D-81479 München (DE)

(56) Entgegenhaltungen:
- EP-A- 0 294 868
- EP-A- 0 370 809
- WO-A-93/08603

## Beschreibung

Die vorliegende Erfindung betrifft einen MOSFET auf SOI-Substrat.

Bei MOSFETs auf sehr dünnen Oberflächenschichten, wie z. B. bei Verwendung von SOI-Substraten mit einer sehr dünnen Nutzschicht aus Silizium (sogenannte Body-Siliziumschicht) zur Herstellung vollständig verarmter (fully depleted) MOSFETs ist die Einsatzspannung stark von der Dicke des Body-Siliziums abhängig, was technologisch nur schwer in den Griff zu bekommen ist. Bei Verwendung von dickeren Schichten hält sich zwar die Einsatzspannung in engen Grenzen, es tritt aber der Kink-Effekt auf, der eine Verschiebung des Substratpotentials durch nicht abfließenden Substratstrom bei zunehmender angelegter Spannung hervorruft und der sich nur durch einen Anschlußkontakt an der Body-Siliziumschicht, über den man den Substratstrom ableiten kann, vermeiden läßt. Fully depleted und partially depleted MOSFETs auf SOI-Substrat sind mit Body-Anschluß realisiert worden (z. B. E.P. Ver Ploeg e.a. in IEDM 92, 337 bis 340 (1992)). Die angegebenen Lösungen sind aber zumeist nicht ohne weiteres kompatibel mit dem Gesamtprozeß und erfordern zusätzliche technologische Maßnahmen oder führen zu einer Unsymmetrie der MOSFETs, was für Schaltungsanwendungen von Nachteil ist. Ein SOI - MOSFET gemäß dem Oberbegriff des Anspruchs 1 ist aus der Schift EP-A-370809 bekannt. Aufgabe der vorliegenden Erfindung ist es, einen insbesondere im Hinblick auf die Einsatzspannung und die Auswirkungen des Substratpotentials verbesserten MOSFET auf SOI-Substrat und ein zugehöriges Herstellungsverfahren anzugeben.

Diese Aufgabe wird mit dem MOSFET mit den Merkmalen des Anspruches 1 und mit dem Herstellungsverfahren mit den Merkmalen des Anspruchs 4 gelost. Weitere Ausgestaltungen ergeben sich aus den abhängigen Ansprüchen.

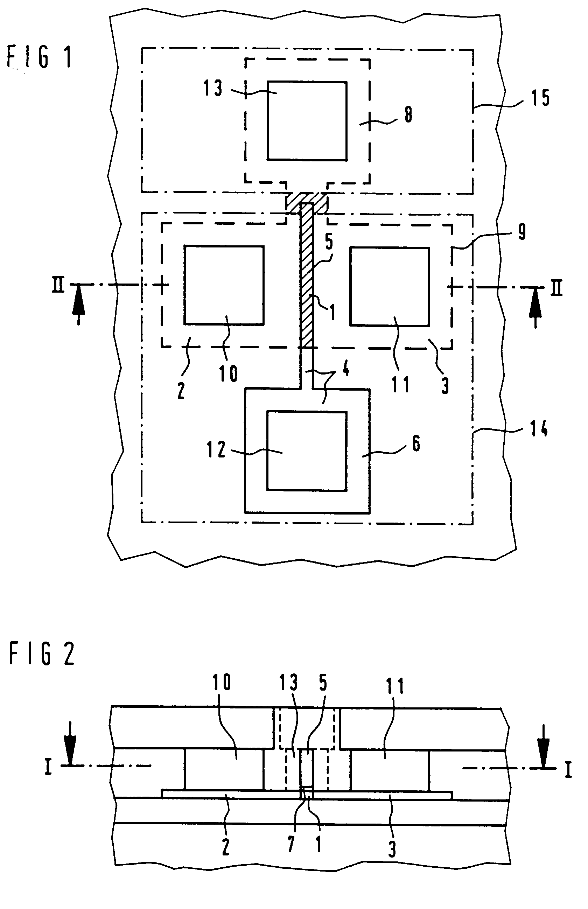

Bei dem erfindungsgemäßen MOSFET ist außer den Bereichen für Source, Kanal und Drain ein weiterer Bereich, der vorzugsweise lateral dazu angeordnet ist und für elektrischen Anschluß ausreichend hoch dotiert ist, vorhanden. Dieser weitere Bereich ist elektrisch leitend mit dem Kanalbereich verbunden und für denselben Leitfähigkeitstyp dotiert, so daß über den zugehörigen Anschlußkontakt ein weiteres Potential direkt an den Kanalbereich angelegt werden kann. Diese zu dem MOSFET gehörenden dotierten Bereiche sind in der Body-Siliziumschicht eines SOI-Substrates z. B. in Form einer Mesa oder mittels einer rings umgebenden LOCOS-Isolation hergestellt. Die Gate-Elektrode ist im Prinzip wie bei MOSFETs üblich aufgebracht. Die Gate-Elektrode ist stegförmig über den Kanalbereich geführt. Ein Ende dieses Steges ragt nicht oder nur sehr wenig über den Kanalbereich hinaus. Damit werden unerwünschte zusätzliche Kapazitäten zwischen der Gate-Elektrode und den Source- und Drain-Bereichen möglichst klein gehalten. Das andere Ende des Steges ist zu dem üblichen Gate-Anschlußbereich erweitert. Implantierungen von Dotierstoff sind so vorgenommen, daß der hoch dotierte Anschlußbereich für den Kanalbereich von den entgegengesetzt dazu dotierten Bereichen von Source und Drain zumindest durch einen schmalen Anteil des niedriger dotierten Kanalbereiches getrennt ist. Es folgt eine Beschreibung des erfindungsgemäßen MOSFET anhand der Figuren 1 und 2.
- Figur 1: zeigt einen erfindungsgemäßen MOSFET in Aufsicht.
- Figur 2: zeigt den MOSFET der Figur 1 in dem dort eingezeichneten Schnitt.

Der erfindungsgemäße MOSFET wird am einfachsten anhand des Herstellungsverfahrens beschrieben. Ein ringsum elektrisch isolierter Bereich, der für den MOSFET vorgesehen ist, wird in einer Body-Siliziumschicht eines SOI-Substrates hergestellt, indem z. B. in dieser Schicht eine Mesa 9 (gestrichelte Umrandung in Figur 1) hergestellt wird oder der betreffende Bereich ringsum durch eine LOCOS-Isolation elektrisch isoliert wird. Bei dem in Figur 1 dargestellten Ausführungsbeispiel ist das Silizium der Body-Siliziumschicht rings um die als verdeckte Kontur gestrichelt eingezeichnete Mesa 9 bis zur darunter befindlichen Isolatorschicht vollständig entfernt. In diesen Bereich der Mesa 9 wird eine Grunddotierung für den Kanalbereich 1, der schraffiert eingezeichnet ist, eingebracht. Wie bei MOSFETs üblich kann die Gate-Elektrode 4 auf eine z. B. durch Oxidation an der Oberfläche der Mesa 9 hergestellte Dielektrikumschicht aufgebracht und strukturiert werden.

Die Gate-Elektrode 4 ist bei dem erfindungsgemäßen MOSFET durch einen Steg 5 über dem Kanalbereich 1 und einen damit verbundenen Anschlußbereich 6 gebildet. Dieser Anschlußbereich 6 wird bei Verwendung einer Mesa 9 unmittelbar auf die Isolatorschicht des SOI-Substrates aufgebracht. Der Steg 5 der Gate-Elektrode sollte in den seitlichen Abmessungen möglichst mit dem zwischen dem Source-Bereich 2 und dem Drain-Bereich 3 befindlichen Anteil des Kanalbereiches 1 übereinstimmen. Das dem Anschlußbereich 6 gegenüberliegende Ende des Steges 5 sollte über diesen zwischen Source und Drain befindlichen Anteil des Kanalbereiches 1 nicht mehr hinausragen, als aufgrund des Herstellungsprozesses unbedingt nötig ist. Nur auf der anderen Seite befindet sich ein kurzer Abschnitt des Steges 5 als Verbindung zu dem Anschlußbereich 6.

Eine für Source und Drain sowie die Gate-Elektrode vorgesehene Implantierung erfolgt unter Verwendung einer Maske in dem strichpunktiert umrandeten Bereich 14. Eine Implantierung entgegengesetzten Vorzeichens für den Anschlußbereich 8 des Kanalbereiches 1 erfolgt in dem strichpunktiert umrandeten Bereich 15 mittels einer weiteren Maske. Bei üblicherweise gleichzeitig hergestellten komplementären MOSFETs sind Implantierungen beider Vorzeichen ohnehin erforderlich, so daß durch die geeignete Wahl der Maskenöffnungen in effizienter Weise die für den erfindungsgemäßen MOSFET erforderlichen Implantierungen im Rahmen des CMOS-Herstellungsprozesses erfolgen können. Um durch den hoch dotierten Kanal-Anschlußbereich 8 die Funktionsweise des MOSFET nicht zu beeinträchtigen, ist ein direktes Angrenzen dieses Kanal-Anschlußbereiches 8 an den Source-Bereich 2 bzw. den Drain-Bereich 3 vermieden. In dem beschriebenen Ausführungsbeispiel der Figur 1 ist das dadurch bewerkstelligt, daß ein schmaler Anteil des Kanalbereiches 1 noch zwischen dem Kanal-Anschlußbereich 8 und dem Source-Bereich 2 bzw. dem Drain-Bereich 3 vorhanden ist. Da der Kanalbereich 1 die relativ niedrige Grunddotierung aufweist, ist dadurch vermieden, daß hoch dotierte Anschlußbereiche unterschiedlichen Vorzeichens direkt aneinander angrenzen. Im Prinzip kann auch die Verbindung zwischen dem Kanal-Anschlußbereich 8 und dem zwischen Source und Drain befindlichen Anteil des Kanalbereiches 1 auf die Breite dieses Kanalbereiches 1 beschränkt sein. Die Herstellung wird aber vereinfacht, wenn der dotierte Bereich zwischen Source, Drain und dem Kanal-Anschlußbereich 8 etwas breiter ist. Durch den Abstand der Bereiche, die von den Öffnungen der Masken bei den Implantierungen eingenommen werden, wird erreicht, daß der schmale, in Längsrichtung von Source, Kanal und Drain, d. h. quer zur Längsrichtung des Steges 5 verlaufende niedrig dotierte Anteil des Kanalbereiches zwischen dem Kanal-Anschlußbereich 8 und den Bereichen von Source und Drain 2, 3 übrigbleibt.

Figur 2 zeigt den in Figur 1 eingezeichneten Querschnitt. Zwischen dem Kanalbereich 1 und dem Steg 5 der Gate-Elektrode ist die als Gate-Oxid fungierende Dielektrikumschicht 7 eingezeichnet, die bei diesem Ausführungsbeispiel der Einfachheit halber auf die Breite des Steges 5 rückgeätzt ist. Es genügt aber, wenn die Dielektrikumschicht nur in den Bereichen entfernt wird, in denen die Kontakte 10, 11, 13 aufgebracht werden. Der auf dem Kanal-Anschlußbereich 8 aufgebrachte Kontakt 13 ist in Figur 2 als verdeckte Kontur gestrichelt eingezeichnet. Ebenfalls schematisch angedeutet ist eine erste Metallisierungsebene für den Anschluß bzw. die weitere Verschaltung der Kontakte. Der MOSFET ist z. B. von einer Dielektrikumschicht bedeckt und planarisiert. Die beschriebene MOSFET-Struktur ist voll kompatibel mit dem CMOS-Prozeß auf SOI-Substrat. Er läßt sich daher auf einfache Weise zusammen mit den bisher bekannten MOSFETs und anderen Bauelementen im Rahmen dieses Gesamtprozesses realisieren.

## Patentansprüche

1. MOSFET auf einem SOI-Substrat mit einer Body-Siliziumschicht auf einer Isolatorschicht,
bei dem ein dotierter Source-Bereich (2), ein dotierter Drain-Bereich (3) und dazwischen ein für den entgegengesetzten Leitfähigkeitstyp dotierter Kanalbereich (1) in der Body-Siliziumschicht ausgebildet sind,
bei dem eine Gate-Elektrode (4) vorhanden ist, die aus einem geradlinigen Steg (5), der über diesem Kanalbereich (1) verläuft, und einem Gate-Anschlußbereich (6) besteht,
bei dem dieser Steg (5) von diesem Kanalbereich (1) durch eine Dielektrikumschicht (7) elektrisch isoliert ist,
bei dem ein mit dem Kanalbereich (1) elektrisch leitend verbundener, hoch dotierter Kanal-Anschlußbereich (8) vorhanden ist,
bei dem dieser Source-Bereich (2), dieser Drain-Bereich (3), dieser Gate-Anschlußbereich (6) und dieser Kanal-Anschlußbereich (8) jeweils mit einem Kontakt (10, 11, 12, 13) versehen sind,
dadurch gekennzeichnet, daß :
zwischen dem Kanal-Anschlußbereich und dem Source-Bereich und zwischen dem Kanal-Anschlußbereich und dem Drain-Bereich ein außerhalb des von der Gate-Elektrode bedeckten Anteils der Body-Siliziumschicht angeordneter Bereich vorhanden ist, der die gleiche Dotierung aufweist wie die des Kanalbereichs.

2. MOSFET nach Anspruch 1,
bei dem die Gate-Elektrode (4) Polysilizium ist.

3. MOSFET nach Anspruch 1 oder 2,
bei dem der Steg (5) mit Ausnahme eines für eine elektrisch leitende Verbindung mit dem Gate-Anschlußbereich (6) erforderlichen Anteils nur über dem Kanalbereich (1) zwischen dem Source-Bereich und dem Drain-Bereich vorhanden ist.

4. Verfahren zur Herstellung eines MOSFET nach einem der Ansprüche 1 bis 3, bei dem
in einem ersten Schritt ein für den MOSFET vorgesehener Bereich in einer Body-Siliziumschicht eines SOI-Substrates ringsum elektrisch isoliert wird und mit einer für den Kanalbereich (1) vorgesehenen Grunddotierung und mit einer dünnen Dielektrikumschicht (7) an seiner Oberfläche versehen wird,
in einem zweiten Schritt eine für die Gate-Elektrode (4) vorgesehene Schicht aufgebracht und strukturiert wird,
in einem dritten Schritt unter Verwendung von Masken, deren Öffnungen nicht aneinander angrenzende Bereiche einnehmen, Implantierungen von Dotierstoffen für den Source-Bereich (2), den Drain-Bereich (3) und die Gate-Elektrode (4) sowie für den Kanal-Anschlußbereich (8) erfolgen und
in einem vierten Schritt diese Dotierstoffe aktiviert und die Kontakte hergestellt werden.

## Claims

1. MOSFET on an SOI substrate having a body silicon layer on an insulator layer,
in which a doped source region (2), a doped drain region (3) and, in between, a channel region (1), which is doped for the opposite conductivity type, are formed in the body silicon layer,
in which a gate electrode (4) is present, which comprises a straight web (5), which runs over this channel region (1), and a gate terminal region (6),
in which the said web (5) is electrically insulated from the said channel region (1) by a dielectric layer (7),
in which a heavily doped channel terminal region (8), which is electrically conductively connected to the channel region (1), is present,
in which the said source region (2), the said drain region (3), the said gate terminal region (6) and the said channel terminal region (8) are respectively provided with a contact (10, 11, 12, 13),
characterized in that:
a region which is arranged outside that portion of the body silicon layer which is covered by the gate electrode is present between the channel terminal region and the source region and between the channel terminal region and the drain region, and has the same doping as that of the channel region

2. MOSFET according to Claim 1,
in which the gate electrode (4) is polysilicon.

3. MOSFET according to Claim 1 or 2,
in which the web (5), with the exception of a portion which is required for an electrically conductive connection to the gate terminal region (6), is present only over the channel region (1) between the source region and the drain region.

4. Method for the production of a MOSFET according to one of Claims 1 to 3, in which,
in a first step, a region which is provided for the MOSFET in a body silicon layer of an SOI substrate is electrically insulated all around and is provided with a base doping, which is provided for the channel region (1), and with a thin dielectric layer (7) on its surface,
in a second step, a layer which is provided for the gate electrode (4) is applied and structured,
in a third step, using masks whose openings do not occupy mutually adjoining regions, implantations of dopants for the source region (2), the drain region (3) and the gate electrode (4) as well as for the channel terminal region (8) are carried out, and
in a fourth step, these dopants are activated and the contacts are established.

## Revendications

1. MOSFET sur un substrat SOI ayant une couche de silicium "body" sur une couche isolante,
dans lequel une zone de source (2) dopée, une zone de drain (3) dopée et, entre les deux, une zone de canal (1) dopée pour le type de conductivité opposée sont réalisées dans la couche de silicium "body",
dans lequel existe une électrode de grille (4), qui est composée d'un pont (5) rectiligne passant au-dessus de cette zone de canal (1) et d'une zone de jonction de grille (6),
dans lequel ce pont (5) est isolé électriquement de cette zone de canal (1) par une couche diélectrique (7),
dans lequel existe une zone de jonction de canal (8) fortement dopée communiquant avec la zone de canal (1) de manière à laisser passer le courant,
dans lequel cette zone de source (2), cette zone de drain (3), cette zone de jonction de grille (6) et cette zone de jonction de canal (8) sont pourvues respectivement d'un contact (10, 11, 12, 13),
caractérisé en ce qu'il existe entre la zone de jonction de canal et la zone de source, et entre la zone de jonction de canal et la zone de drain, une zone disposée en dehors de la partie couverte par l'électrode de grille de la couche de silicium "body", dont le dopage correspond à celui de la zone de canal.

2. MOSFET selon la revendication 1, dans lequel l'électrode de grille (4) est du polysilicium.

3. MOSFET selon la revendication 1 ou 2, dans lequel le pont (5) passe uniquement au-dessus de la zone de canal (1) entre la zone de source et la zone de drain, à l'exception d'une partie nécessaire à une liaison conductrice avec la zone de jonction de grille (6).

4. Procédé de fabrication d'un MOSFET selon l'une des revendications 1 à 3, dans lequel
dans une première phase, une zone prévue pour le MOSFET dans une couche de silicium "body" d'un substrat SOI est isolée électriquement sur tout le pourtour et est pourvue d'un dopage de base prévu pour la zone de canal (1) ) et d'une mince couche diélectrique (7) à sa surface,
dans une deuxième phase, une couche prévue pour l'électrode de grille (4) est appliquée et structurée,
dans une troisième phase, des implantations d'agents de dopage pour la zone de source (2), la zone de drain (3) et l'électrode de grille (4) ainsi que pour la zone de jonction de canal (8) sont réalisées, en utilisant des masques dont les ouvertures occupent des zones non contiguës, et
dans une quatrième phase, ces agents de dopage sont activés et les contacts établis.
